# EUROPEAN PATENT APPLICATION

(11) **EP 2 408 036 A1**
(43) Date of publication of application: **18.01.2012**
(21) Application number: 10169845.4
(22) Date of filing: 16.07.2010
(51) Int. Cl.: H01L 51/42

(54) **Device responsive to electromagnetic radiation**

(71) Applicant: Hitachi Ltd., Tokyo (JP)
(72) Inventor: Williams, David, Cambridge, Cambridgeshire CB1 2EB (GB); Brossard, Frederic, Cambridge, Cambridgeshire CB3 9JB (GB)
(74) Representative: Piotrowicz, Pawel Jan Andrzej

(57) **Abstract**

A device (1) which is responsive to electromagnetic radiation (2) is described. The device comprises an absorption region (6) for electromagnetic radiation and first and second electrodes (5, 7) providing contacts to the absorption region. The absorption region includes a layer (6₁) which comprises an aggregation of patterned conductive structures (10), for example periodic structures such as grating and/or spirals, embedded in a radiation-absorbing matrix (11). The conductive structures are configured to increase radiation absorption by the matrix through surface plasmon generation. The conductive structure can be conveniently formed using a lift-off process.

## Description

The present invention relates to a device responsive to electromagnetic radiation, such as a photovoltaic cell or a photodetector.

Considerable effort is being directed to developing so-called "third-generation" photovoltaic cells. It is hoped that third-generation photovoltaic cells will offer better performance and be cheaper to manufacture.

Several different ways of increasing light absorption and enhancing carrier generation, extraction and transport are being investigated. For example, some devices use surface plasmons to increase absorption or to enhance carrier generation and reference is made to WO 2008 150295 A and WO 2005 114748 A. Reference is also made to WO 2008 12516 A and WO 2007 118815 A.

Some of the structures being proposed, particularly those involving surface gratings, can suffer drawbacks. For example, a surface grating tends to be highly sensitive to polarization.

The present invention seeks to provide an improved device which is responsive to electromagnetic radiation, such as a photovoltaic cell or photodetector.

According to the present invention there is provided a device responsive to electromagnetic radiation, the device comprising an absorption region for electromagnetic radiation and first and second electrodes providing contacts to the absorption region, wherein the absorption region includes a layer comprising an aggregation of patterned conductive structures embedded in a radiation-absorbing matrix the patterned conductive structures configured to increase radiation absorption by the matrix through surface plasmon generation.

The patterned conductive structures can enhance the optical field at the interface between the conductive structure and the matrix which can allow more photons to be absorbed and/or electron-hole pairs to be generated.

The patterned conductive structures may comprise apertures and/or slits, which may be closed (e.g. in the case of a hole or slit in a grating) or open (e.g. in the case of a spiral. The patterned conductive structure may comprise an oscillating structure, such as a bent or curved wire or strip, which resembles a section of a square wave, sine wave, triangle wave or other form of periodic structure.

The device may further comprise another layer separating the layer from the first or second electrodes for helping to allow an electric field to be sustained across the absorption region.

The patterned conductive structures may have dimensions (e.g. length, width and thickness or diameter) which are equal to or less than about 5 µm, equal to or less than 2µm or equal to or less than about 1 µm. The conductive structures comprise a material having a skin depth δ and the patterned conductive structures may have at least one dimension, e.g. thickness, which is between about δ to about 2δ The conductive structures may have at least one dimension which may be between about 20 nm and 100 nm or between about 25 nm and about 75 nm.

The patterned conductive structures may comprise structures having different shapes, different sizes and different orientations. This can help increase the range of wavelengths absorbed by the device and decrease sensitivity to polarization.

The patterned conductive structures preferably comprise a highly-conductive material, i.e. a material, for example a metal, having a conductivity of at least about 10 x 10⁶ Ω⁻¹m⁻¹, such as gold, copper, nickel, platinum, aluminium or silver. Different patterned conductive structures may comprise different materials, e.g. some patterned conductive structures may comprise gold and other patterned conductive structures may comprise silver.

The patterned conductive structures may include periodic structures, such as gratings and/or spirals, or other structure having a unit or feature (e.g. a slit or a pair of slits) which is repeated at least once. The absorption region can include a range of different shapes, some periodic and some not, and the periodic structures can include more than one different shape of structures, for example, a mixture of gratings and spirals. The shapes can also have a range of different sizes. For example, the absorption region may include gratings of different sizes, aspect ratios, different periods etc. A feature forming the periodic structure may have a period of an order of magnitude of 0.1 λ or 1λ.

The patterned conductive structures may comprise non-periodic structures comprising features, such as holes, having a dimension and/or separation of an order of magnitude of 0.01 λ or 0.1λ.

The conductive structures may include (topologically) simply-connected shapes. The conductive structures can be generally flat.

The conductive structures can be formed by a lift off process. Thus, the conductive structures can be easily produced and, since the structures are suspended in a solvent, they can be easily processed, e.g. by mixing.

The matrix may comprise an organic material, such as a polymer, and/or may be a conductive material, such as an organic semiconductor material.

The device may be a photovoltaic cell or a photodetector responsive to electromagnetic radiation in and/or near to the optical region of the electromagnetic spectrum.

Certain embodiments of the present invention will now be described, by way of example, with reference to the accompanying drawings in which:
Figure 1 illustrates a device which is responsive to electromagnetic radiation;
Figure 2 is a cross section of the device shown in Figure 1 taken along the line A-A';
Figure 3 is a plan view of a grating which can be used in an absorption layer;
Figure 4 is a cross section of the grating shown in Figure 3 taken along the line B-B';
Figure 5 is a plan view of sheet having holes which can be used in an absorption layer;
Figure 6 illustrates a flat spiral which can be used in an absorption layer;
Figures 7a to 7d illustrates operation of the photovoltaic cell shown in Figure 1;
Figure 8 illustrates generation of a surface plasmon and creation of an electron-hole pair;
Figures 9a to 9b illustrates stages during a lift-off process which can be used to fabricate structures for use in an absorption layer;
Figure 10 illustrates a suspension, for example, formed by a lift-off process;
Figure 11 illustrates mixing suspensions of structures; and
Figures 12a to 12f illustrates stages during the fabrication of the device shown in Figure 1.

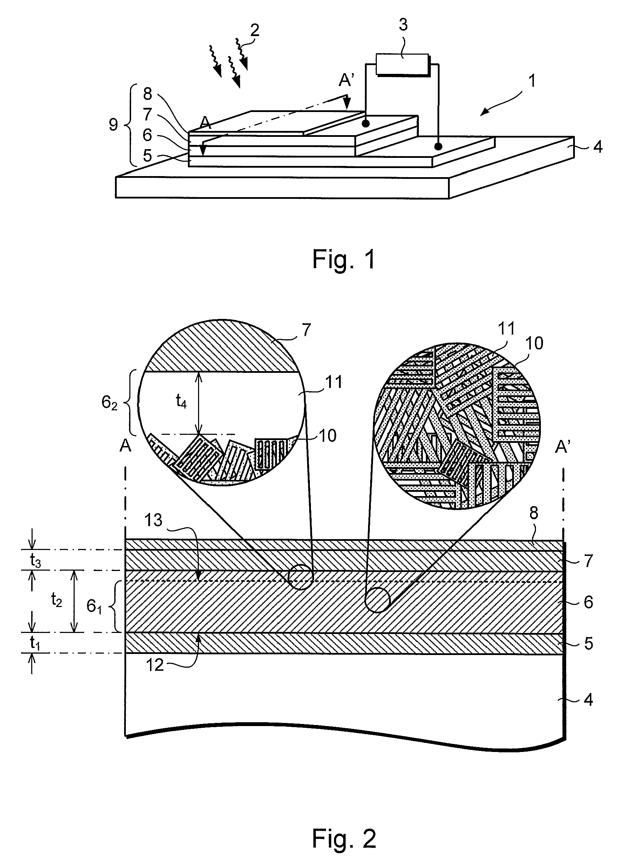

Referring to Figure 1, a device 1 which is responsive to electromagnetic radiation 2 is shown. For a photovoltaic cell, the electromagnetic radiation can have a range of wavelengths, e.g. λ₁ to λ₂, e.g. lying in or near the optical region of the spectrum, typically from about 300 to 1000 nm. The device 1 is connected to an external circuit 3. In this example, the device 1 takes the form of a photovoltaic cell and the external circuit 3 is a load.

Referring also to Figure 2, the device 1 includes a substrate 4, for example made of silicon, glass or plastic, supporting a first electrode 5, an absorption region 6, a second electrode 7 and an optional anti-reflection coating 8.

In this example, the first electrode 5, absorption region 6, second electrode 7 and anti-reflection coating 8 are provided by respective layers arranged in a stack 9 on the substrate 4, with the absorption layer 6 sandwiched between a bottom electrode 5 and an upper electrode 7. The bottom electrode 5 is formed of gold or other suitable conductive material. The upper electrode 7 is formed of a conductive material which is transparent to the electromagnetic radiation 2. Thus, for a photovoltaic cell operating in or near the optical part of the electromagnetic spectrum, the upper electrode 7 may comprises indium-tin oxide (ITO).

Referring in particular to Figure 2, the absorption region 6 comprises an aggregation of conductive structures 10 embedded in a light-absorbing matrix 11.

The conductive structures 10 are formed from a highly-conductive material, such as gold, silver or copper or other highly-conductive metal, and are preferably micrometre- or nanometre-sized. The conductive structures 10 are patterned, e.g. with apertures or slots (which can be closed- or open-ended). The conductive structures 10 can be periodic structures, such as gratings, spirals and/or other structures having regularly-spaced or periodic features which are suitable for coupling incoming photons into surface plasmons. However, the conductive structures 10 can be aperiodic structures which achieve the effect. As will be explained in more detail later, the conductive structures 10 can be conveniently formed by a lift-off process. The conductive structures 10 are sufficiently closely packed so to touch or contact neighbouring conductive structure. In some embodiments, some or all of the conductive structures 10 do not touch their neighbouring conductive structures 10 but are still sufficiently close to conduct charge carriers through the aggregation of conductive structures 10. For example, depending on conductivity of the matrix, conductive structures can be separated by, for example, less than or equal to 20 nm, less than or equal to 10 nm, less than or equal to 5 nm, less than or equal to 2 nm or less than or equal to 1 nm. The conductive structures 10 can have different shapes, a range of sizes and/or a range of orientations so as to help the device broaden the range of absorbed wavelengths and reduce its sensitivity to polarization. The conductive structures 10 are formed from a layer of the highly-conductive material. However, the conductive structures 10 can be formed from two or more layers of different materials. Moreover, a range of different materials can be used in the aggregation. As will be explained later, the conductive structures 10 help to concentrate light and the aggregation serves to increase surface area and enhance absorption of photons. In this and certain embodiments, the conductive structures 10 do not absorb radiation, although in some embodiments they can absorb at least some light. Thus, in this and certain embodiments, the matrix 11 absorbs substantially all of the light that is absorbed in the absorption region 6.

The matrix 11 is formed from a material which absorbs electromagnetic radiation at the given wavelength or range of wavelengths. The matrix 11 can be formed from a conductive material, but one which is less conductive than the highly-conductive material used to form the conductive structure 10. The matrix 11 can comprise an organic material or polymer and which can be semiconducting, such as pentacene, poly 3-hexylthiophene (P3HT) or phenyl C61 butyric acid methyl ester (PCBM). However, the matrix can be formed from an inorganic material, e.g. lithium tetrachloroaluminate or other lithium salt. The matrix 11 can comprise an organic or inorganic semiconductor, and other suitable materials are described in WO 2007 118815 A. The matrix 11 preferably comprises a material having a high electron- or hole-mobility.

The conductive structures 10 and the matrix 11 are suitably configured to help generate surface (propagating) plasmons:
The conductive structures 10 and the matrix 11 are made from materials having relative permittivity values, ε_{1,} ε₂ which are of opposite sign and different magnitudes, i.e. |ε₁| > |ε₂| or |ε₁| < |ε₂|. Thus, conductive structures 10 can be formed from metals, particularly noble metals and the matrix 11 can be formed from a dielectric. For example, neglecting the imaginary part of its relative permittivity silver has values of relative permittivity of -3.8, -13.4 and -26 at wavelengths of 400 nm, 600 nm and 800 nm respectively. Pentacene has corresponding values of permittivity of 2.6, 2.5 and 2.6. It will be appreciated that a suitable combination of materials can be found be inspecting the values of permittivity and/or by routine experiment.

The conductive structures 10 are configured so as to aid excitation of plasmons. For example, this can be achieved by adding a periodic or quasi-periodic modulation to the surface of the conductor. The periodicity, particularly when periodicity is about a half of the photon wavelength, helps to open up a band gap in plasmon dispersion characteristic. Plasmons are generally generated outside the bandgap, otherwise light is reflected. The periodicity of modulation can be chosen to vary the plasmon wavelength and to match a region of the electromagnetic spectrum, for example, in or around the optical and near-infrared regions. Alternatively, localized (non-propagating) plasmons can be excited in the vicinity of nano-holes created in a metal host. The size, shape and/or the density (separation) of the nanoholes control the plasmons wavelength without the need for periodicity.

Once generated, a plasmon is confined to the surface of the metal resulting in high optical field intensity. This creates a large number of electron-hole pairs by the matrix 11. The electrons can be collected at the metallic host with limited space for recombination and directed towards the cathode of the solar cell, via a built-in electric field such as provided by a Schottky contact.

The absorption region 6 absorbs electromagnetic radiation and generates surface plasmons which produce electron-hole pairs. The electrons and holes separate under an external field, e.g. due to the electrodes 5, 7 having different work functions, and propagate to separate electrodes 5, 7. The absorption region 6 provides a three-dimensional plasmonic hybrid meta-material.

As shown in Figure 2, the absorption region 6 is arranged so that it comprises at least two contiguous layers or regions 6₁, 6₂. The conductive structures 10 are confined to a lower layer 6₁ leaving a thin upper spacer layer or region 6₂ in contact the electrode 7 free of conductive structures 10. In the lower layer 6₁, the conductive structures 10 are sufficiently closely packed so as to form at least one conductive path between lower and upper surfaces 12, 13 of the layer. The spacer layer 6₂ is used to prevent formation of a highly-conductive path between the electrodes 5, 7 which would otherwise prevent a sufficiently large electric field to be sustained across the absorption layer 6.

Referring still to Figure 2, the bottom electrode 5 has a thickness, t₁, typically of between about 50 to 200 nm. The absorption layer 6 has a thickness, t₂, which depends on the wavelength and matrix absorption coefficient. The thickness should be thick enough so that most, if not all, of the light is absorbed by the matrix and converted to electron-hole pairs. Typically, the thickness, t₂, can lie in the range from about 100 nm (e.g. for organic materials) to several micrometers (e.g. for a semiconductor). For example, the thickness of material required to absorb (1-(1 /e)) (about 0.64) of the incident light without the conductive structures 10 can be calculated using the Beer—Lambert law. For pentacene, the thickness required to absorb this proportion of light is about 1.0 µm for light at a wavelength of 400 nm, 0.5 µm at a wavelength of 600 nm and about 3.2 µm at a wavelength of 800 nm. However, these values will be reduced with conductive structures 10 since absorption is increased. Thus, the thickness, t₂, when using pentacene can lie in the region of about 0.2 µm to 5 µm, preferably about 0.5 to about 2 µm. The top electrode 6 has a thickness, t₃, typically of between about 50 to 200 nm. The spacer layer 6₂ has a thickness, t₄, between about 1 nm and about 100 nm, e.g. about 10 nm. The thickness is chosen to maximise the electric field sustained across the absorption region, while minimising resistance. The thicknesses can be found by routine experiment.

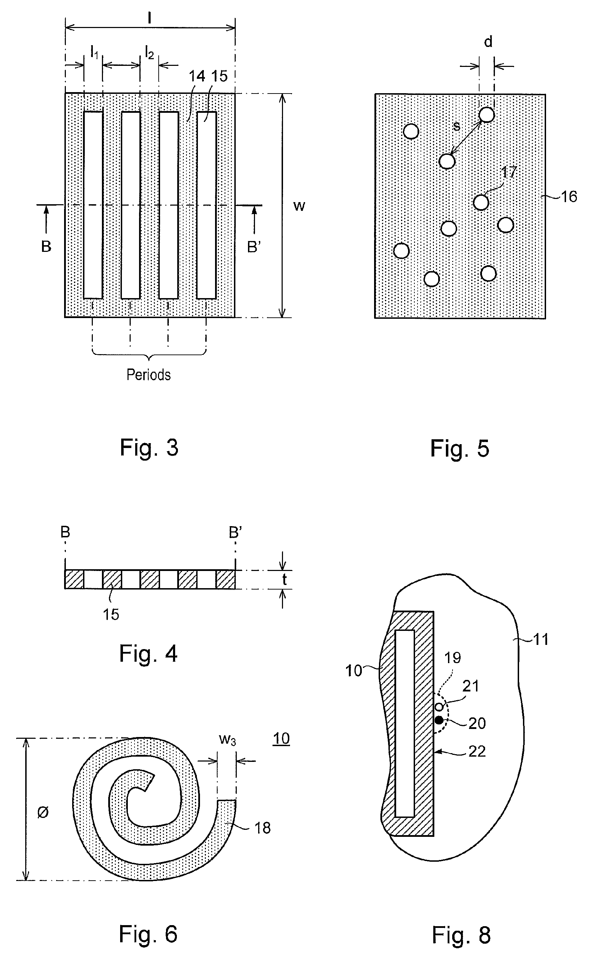

Referring also to Figures 3 and 4, some or all of the conductive structures may take the form of flat gratings comprising periodic members 14 in the form of bars which define slits 15 between the members 14. As explained earlier, the gratings (or other periodic structures) are generally structured and are sized so that they interact with (e.g. diffract) electromagnetic radiation having a wavelength, λ, or a range of wavelengths, e.g. λ₁ to λ_{2.} In the case of a range of wavelengths (λ₁ to λ₂), a mean or median value of the range can be used. For example, for solar radiation a value of wavelength of about 600 nm can be used. Alternatively, the longest wavelength can be used. For example, for solar radiation, this can be taken to be about 800 nm. The periodicity of the modulation is on the order of the wavelength, λ, or on the order of 0.1 λ and typically lies in the range from about 50 nm to about 1 µm, preferably in the range from about 50 nm to about 500 nm. The grating can have a few periods, preferably in the range between about 2 to 10 and more preferably about 5 periods, i.e. a sufficient number of periods to couple the incoming light to surface plasmons. In Figures 3 and 4, the grating has 3 periods. The length, 1, of conductive structures can lie in a range which can have a lower limit of about 100 nm, about 200 nm, about 300 nm or about 400 nm and can have an upper limit of about 1 µm, about 2 µm, about 5 µm or about 10 µm. The length, 1, can lie in in the range between about 250 nm to about 5 µm. The width, w, can be on the order of the wavelength, λ. For example, the width can be about λ to about 10 λ. For example, the width, w, of conductive structures, can lie in the range between about 300 nm to 10 µm

The conductive structure 10 has a thickness, t, of the order of the skin depth, δ, of the conductive structure 10 and which is typically about 30 nm to about 100 nm. The thickness, t, preferably lies in the range between about δ to about 2δ. For example, for gold and silver, the skin depth is about 33 nm to about 25 nm for wavelengths of 400 nm to 800 nm. Thus, the thickness, t, can be between about 20 nm and 100 nm, preferably about 25 to 65 nm for silver, gold and other materials having similar skin depths. Using a thin conductive structure 10 can help plasmons to be excited on opposite faces of the conductive structure. Thus, irrespective of which face is irradiated, electron-hole pairs creation is enhanced on both sides of the structure. Using a thin conductive structure 10 can also help to minimise absorption by the conductive structures themselves. It can also help to minimise the volume of the absorption region occupied by the conductive structures. However, in some embodiments, the thickness, t, can be much higher.

The conductive structures 10 typically have a cross-section ratio (length to thickness) equal to or greater than about 10.

As mentioned earlier, the conductive structures 10 may be non-periodic but still serve to enhance absorption by the matrix 11. For example, as shown in Figure 6, the conductive structure can take the form of a sheet 16 with holes 17, for example similar to structures described in "Optical Spectroscopy of Nanometric Holes in Thin Gold Films" by J. Prikulis, P. Hanarp, L. Olofsson, D. Sutherland and M. Käll, Nano Letters, volume 4, page 1003 1007f (2004). The diameters, d, of the holes 17, the separations, s, between holes and their nearest neighbouring hole, and/or the directions to their nearest neighbouring holes can vary so as to provide an aperiodic structure. For example, different holes can have different diameters, d, lying in a range between about 0.01 λ to about 0.1 λ, typically about 5 nm to 100 nm, e.g. about 50 nm. Additionally or alternatively, a hole and its nearest neighbour can have a separation, s, lying in a range between about 5 nm to 100 nm, e.g. about 50 nm, which can differ from values of separation between other holes and their nearest neighbour.

Referring to Figure 6, some or all of the conductive structures 10 can take the form of flat spirals, e.g. a flat Archimedean spiral. The spirals can have an outer diameter, ∅, of between about 0.5 λ and 10 λ and the spiral track 18 can have a width, w₃, of about 0.2 w or between about 0.1 λ and 1 λ. Spirals can be define an open-ended slit. However, the spiral slit and be closed, e.g. by forming a closed annular frame.

In some embodiments, some or all of the conductive structures are not flat. For example, strain can be introduced into the conductive structures 10 so that they curve or expand (for example in the case of a spiral) to form a three-dimensional structure. The conductive structures may be provided with or include quantum dots or quantum wires.

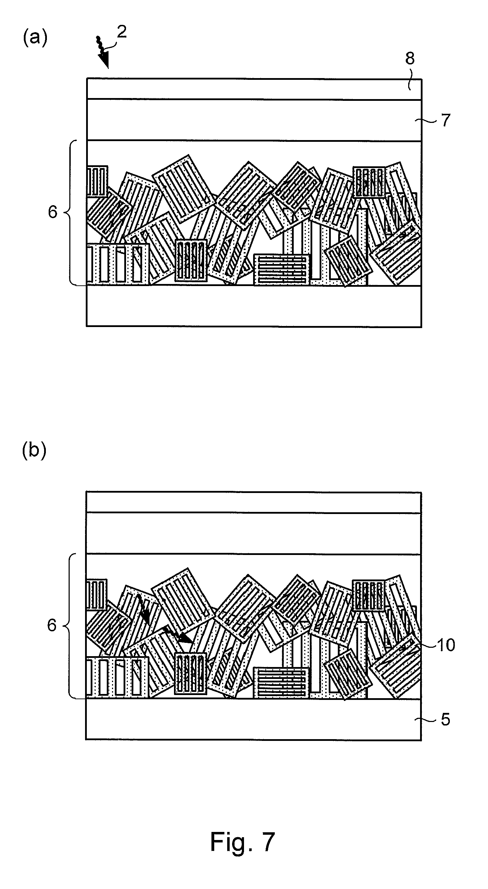

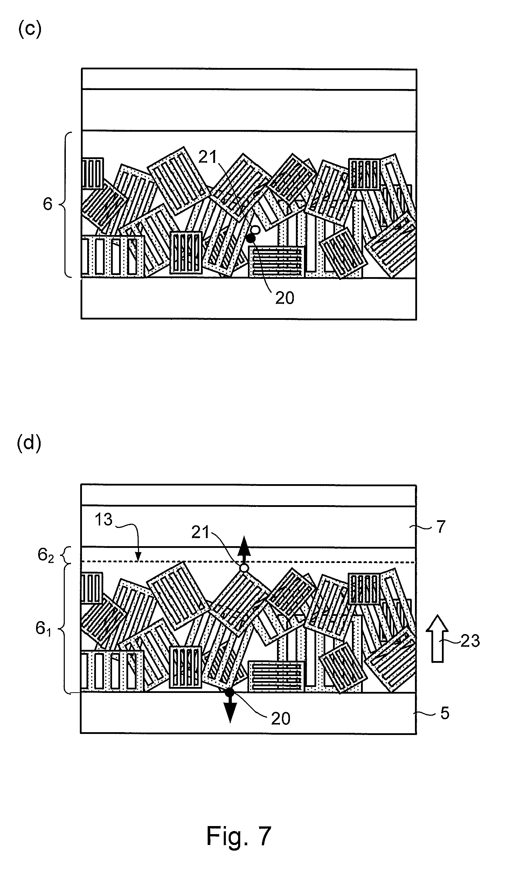

Referring to Figures 7a to 7d, operation of the device will now be described.

Referring in particular to Figure 7a, the device 1 is illuminated with photons 2 (i.e. electromagnetic radiation) which pass through the antireflection coating 8 and the transparent upper electrode 7. For clarity, only one photon is shown and operation will be described with reference to only one photon. It will be appreciated that a photovoltaic cell will used in daylight and so there will be a large number of photons.

Referring in particular to Figure 7b, the photon 2 propagates through the absorption layer 6 until it is absorbed. The photon 2 can be reflected and/or diffracted by the conductive structures 10. The photon 2 can be reflected by the bottom electrode 7 or an optional bottom mirror layer (not shown).

Referring in particular to Figure 7c and 8, the photon 2 is absorbed in the matrix 11 generating a surface plasmon 19 which creates a coupled electron-hole pair 20, 21. The conductive structure 10 enhances the optical field at the interface 22 between the conductive structure 10 and the matrix 11 which can allow creation of more electron-hole pairs 20, 21.

Referring in particular to 7d, the electron 20 and hole 21 are swept by an electric field 23 towards the upper and lower electrodes 5, 7 respectively. The electric field 23 can be an in-built potential arising, for example, from different work functions of the electrodes 5, 7. Additionally or alternatively, the electric field 23 can be applied from an external voltage source (not shown). The charge carriers 20, 21 reach the edges of the region 6₁ containing the conductive structures 10. In the case of a charge carrier 21 facing a region 6₂ free of conductive structures 10, the charge carrier 21 passes through the spacer region 6₂.

The conductive structures 10 can be formed by patterning a resist using photolithography, electron-beam lithography, ion-beam lithography, x-ray lithography or nano-imprinting, then depositing (e.g. by thermal evaporation) metal and lifting off the metal. Positive or negative resists can be used. In the following, patterning using a positive resist is described.

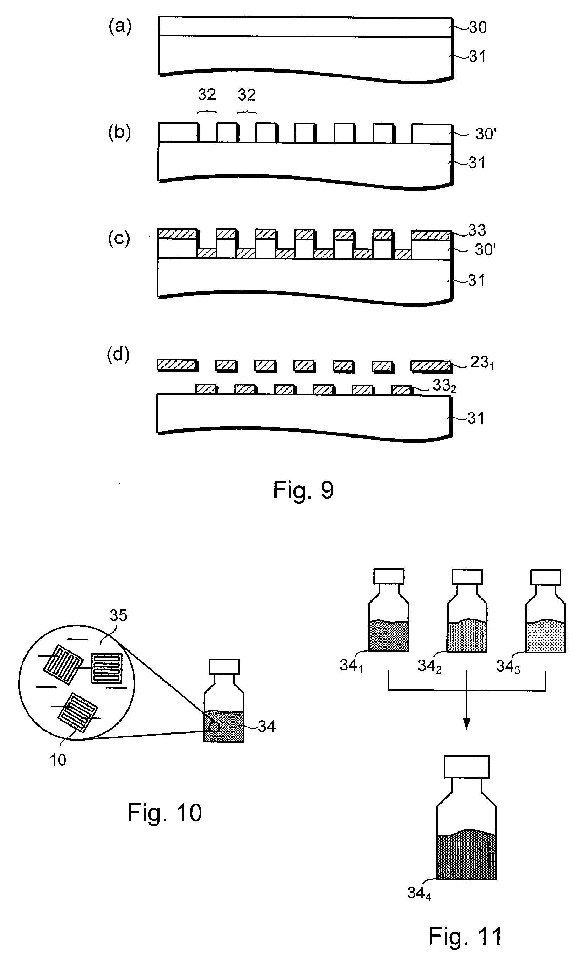

Referring to Figure 9a, a layer 30 of resist is applied to the surface of a wafer 31, e.g. by spin-coating. Typically, the layer 30 has a thickness of the order of a micron. An example of an optical resist is Shipley Microposit S14000-27. An example of an electron-beam resist is polymethylmethacrylate (PMMA). The resist is exposed. For example, PMMA can be exposed by scanning an electron beam tracing an inverse pattern to the desired shape of conductive structures. A beam energy of 20 keV can be used and the exposure may be 1 C/m².

A developer (not shown) is used to remove exposed regions of the resist. For example, a suitable developer for S14000-27 optical resist is Microposit MF 319. A suitable developer for PMMA is 4-methylpentane-2-one (also known as methyl isobutyl ketone or "MIBK") and propyl-2-ol (also known as iso-propyl alcohol or "IPA"). The exposure and/or development are tailored to produce an undercut profile to aid lift-off. The resulting structure, including developed resist 30' and exposed regions 32 of the wafer 31, is shown in Figure 9b.

Referring also to Figure 9c, one or more layers of metal 33 are deposited, e.g. by thermal or e-beam evaporation, over the developed resist 30' and the exposed regions 32 of the wafer 31. For example, about 10 nm of gold is evaporated at a pressure lower than 6 x 10⁻⁶ Torr. A thinner or thicker layer of metal 33 can deposited. The minimum thickness of the layer 33 depends on whether the metal, when lifted off, is stiff enough to prevent it rolling up. The maximum thickness of the layer 33 depends on the thickness and profile of the resist 30' and whether the metal can be successfully lifted off.

A solvent, such as acetone, is used to remove the resist, thereby "lifting off" some of the deposited metal 33₁ and leaving the rest of the metal 33₂ attached to the wafer 31.

During conventional micro- and nano-fabrication processes, lift-off metal is usually a waste by-product. However, here, the lift-off metal 33₁ is used.

Referring to Figure 10, a suspension 34 comprises the conductive structures 10 (e.g. shapes formed by lift off) in a solvent or other carrier 35. The solvent 35 need not the same as the one used in lift-off, i.e. one solvent may be substituted for another which is more suited for deposition of the conductive structures 10. Additives (not shown) can be included which change the surface characteristics of the conductive structures 10 and which can affect how the conductive structures 10 aggregate or cluster.

Referring to Figure 11, two or more suspensions 34₁, 34₂, 34₃, each containing conductive structures 10 with different shapes and/or sizes, can be mixed together to form a new suspension 34₄ which contains a mixture of different conductive structures 10.

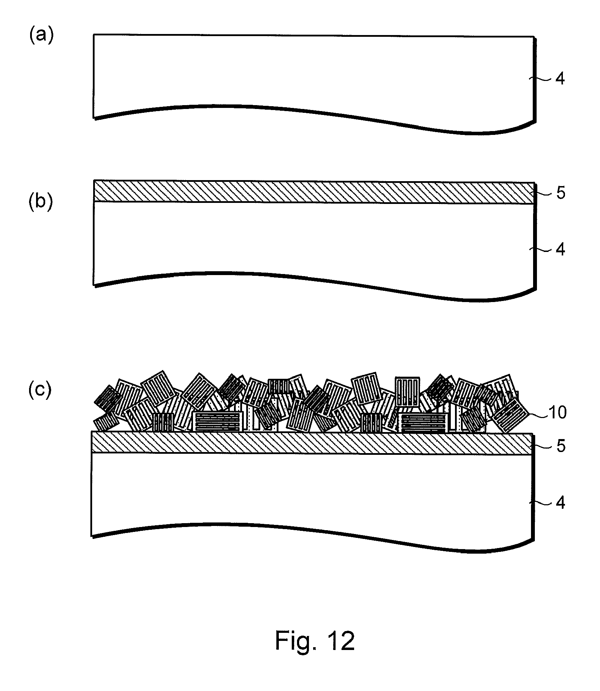

Referring to Figures 12a to 12e, a method of fabricating the device will now be described.

As shown in Figure 12a, a substrate 4 is provided.

Referring to Figure 12b, one or more layers of metal are deposited on the substrate 4 to provide the bottom electrode 5. The bottom electrode 5 can cover the whole substrate 4. Alternatively, the bottom electrode 5 can be patterned, for example using lithography and either lift-off or etch-back, to form a plurality of separate pads on the substrate 4.

A suspension 34 (Figure 10) is then applied, for example, by spin coating.

Referring to Figure 12c, the solvent 35 (Figure 10) evaporates leaving an aggregation of conductive structures 10 lying on the bottom electrode 5.

Further suspension(s) 34 may be applied. For example, this may be done to build up the aggregation to increase its thickness. Additionally or alternatively, different suspensions 24 may be used, thereby forming an aggregation in which the composition (e.g. the shape, size or orientation) of the conductive structures 10 changes with depth. The aggregation can be laterally patterned by, for example, for example using lithography and lift-off or etch-back, to form pads on respective bottom electrodes 5.

Spin-coating generally can be used to produce an aggregation of conductive structures 10 which are disordered or randomly positioned and/or orientated. However, other deposition methods can be used, such as applying conductive structures using Langmuir-Blodgett films or by using other forms of self-ordering films, which result in an ordered arrangement of conductive structure 10, e.g. which are positioned and/or orientated in an ordered way. This can be used, for example, to form a regular array of gratings.

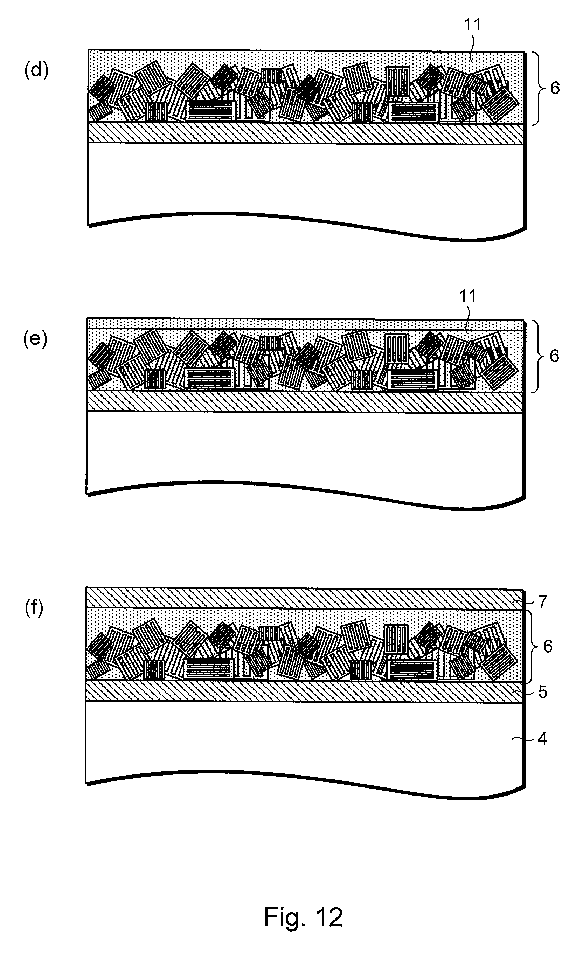

Referring to Figure 12d, the matrix 11 is then added. For example, the matrix 11 may be added dissolved in a solvent. A sufficient amount of the matrix 11 is added so as to cover the conductive structures 10 and leave an amount to form a region 6₂ (Figure 2) free of conductive structures. The solution is then allowed to evaporate or is cured so as to leave the matrix and so form a heterogeneous mixture. Alternatively, the matrix 11 can take the form of a liquid which sets, e.g. on heating. Thus, the space between the conductive structures 10 is back filled resulting in the absorption layer 6.

In some embodiments, the conductive structures 10 and the matrix 11 can be deposited at the same time. For example, a suspension 34 (Figure 10) may include the conductive structures 10 and the matrix material 11.

Referring to Figure 12e, in some embodiment, a thin layer of the matrix material or some other material may be added separately to provide the spacer region 6₂ (Figure 2) free of conductive structures.

Referring to Figure 12f, a layer of transparent conductor, e.g. ITO, is deposited on the absorption layer 6 to provide the top electrode 7. The top electrode 7 can be patterned, for example using lithography and lift-off.

The plurality of orientations and periodicity of a metallic host in a matrix, e.g. dielectric matrix, can help to excite plasmons for virtually any polarization, direction and wavelength of light in the visible to near infrared regions of the electromagnetic spectrum. Photon trapping can be achieved in one or more ways. For example, incoming light can generate regions of strong optical intensity inside the solar cell due to excitation of plasmons or be reflected by the periodically modulated metal. The reflected light can be recycled inside the dielectric matrix due to the different orientations of the host metal providing ways for total internal reflection at the top and bottom interfaces of the solar cell.

It will be appreciated that many modifications can be made to the embodiments hereinbefore described.

The conductive structures need not be gratings, spirals or sheets with holes, but can be any form of extended or sheet-like structure which is patterned in a way to enhance absorption by the matrix. For example, patterning may comprise forming hole(s), slit(s) or aperture(s) which through the structure. Generally, for non-periodic features, the features have a size and./or spacing having an order of magnitude of about 0.01 λ to about 0.1 λ and for periodic features, the features have a size and./or spacing having an order of magnitude of about 0.1 λ to about 1 λ. In some example, patterning can be surface patterning, e.g. formation of recesses.

The layers of the device need not be vertically stacked. For example, the device can be a lateral device with the absorption layer arranged as a strip or pad on the substrate and contact made at or close to the ends of the layer. For instance, electrodes may be spaced apart on the substrate and the absorption layer may be formed as a strip running over the two electrodes. Alternatively, the absorption layer can be formed first and the electrode may be formed running over the ends or sides of the layer.

In the embodiments described earlier, the spacer layer lies on top of the layer containing the conductive structures. However, the layers can be inverted. Furthermore, the absorption region may comprise three or more layers or strata. For example, two spacer layers may sandwich the layer containing the conductive structures. Conversely, a spacer layer may separate two layers which contain the conductive structures.

The device may be provided with a gate.

The device can operate at longer or shorter wavelengths than optical and/or near-optical wavelengths.

## Claims

1. A device responsive to electromagnetic radiation, the device comprising:
an absorption region (6) for electromagnetic radiation (2); and
first and second electrodes (5, 7) providing contacts to the absorption region;
wherein the absorption region includes a layer (6₁) comprising an aggregation of patterned conductive structures (10) embedded in a radiation-absorbing matrix (11), the patterned conductive structures configured to increase radiation absorption by the matrix through surface plasmon generation.

2. A device according to claim 1, wherein the patterned conductive structures (10) comprise apertures and/or slits.

3. A device according to claim 1 or 2, wherein the absorption region includes another layer (6₂) separating the layer from the first or second electrodes for allowing an electric field to be sustained across the absorption region.

4. A device according to any preceding claim, wherein the patterned conductive structures (10) have dimensions which are equal to or less than about 5 µm, optionally, equal to or less than about 2 µm, and, optionally, equal to or less than about 1 µm.

5. A device according to any preceding claim, wherein the patterned conductive structures (10) comprise a material having a skin depth δ and the patterned conductive structures (10) have at least one dimension which is between about δ to about 2δ.

6. A device according to any preceding claim, wherein the patterned conductive structures (10) comprise structures having different shapes.

7. A device according to any preceding claim, wherein the patterned conductive structures (10) comprise structures having different sizes.

8. A device according to any preceding claim, wherein the patterned conductive structures (10) have different orientations.

9. A device according to any preceding claim, wherein the patterned conductive structures (10) comprise a material having a conductivity of at least about 10 x 10⁶ Ω⁻¹m⁻¹, optionally, a highly-conductive metal, such as gold, copper or silver.

10. A device according to any preceding claim, wherein the patterned conductive structures (10) are ordered, for example, in an array or lattice.

11. A device according to any preceding claim, wherein the patterned conductive structures (10) comprise periodic structures.

12. A device according to claim 11, wherein the patterned conductive structures (10) include gratings and/or spirals.

13. A device according to claim 11 or 12, wherein the patterned conductive structures (10) have between 2 and 10 periods.

14. A device according to claim 11, 12 or 13, wherein a feature forming the periodic structure has a period of an order of magnitude of 0.1 λ or 1λ.

15. A device according to any preceding claim, wherein the patterned conductive structures (10) comprise non-periodic structures comprising features, such as holes, having a dimension and/or separation of an order of magnitude of 0.01 λ or 0.1 λ

16. A device according to any preceding claim, wherein the patterned conductive structures (10) are generally flat.

17. A device according to any preceding claim, wherein the patterned conductive structures (10) are formed by a lift off process.

18. A device according to any preceding claim, wherein the matrix (11) comprises an organic material, such as a polymer, and/or a conductive material, such as an organic semiconductor material.

19. A device according to any preceding claim, wherein the device is a photovoltaic cell responsive to electromagnetic radiation in and/or near to the optical region of the electromagnetic spectrum.

20. A device according to any preceding claim, wherein the device is a photodetector responsive to electromagnetic radiation in and/or near to the optical region of the electromagnetic spectrum.
